Europäisches Patentamt

European Patent Office

Office européen des brevets

(19)

(11) EP 0 378 332 B1

(12) **EUROPEAN PATENT SPECIFICATION**

(45) Date of publication and mention
of the grant of the patent:
**03.04.1996 Bulletin 1996/14**

(51) Int Cl.6: **G06F 11/20**

(21) Application number: **90300175.8**

(22) Date of filing: **08.01.1990**

(54) **Semiconductor memory device with redundancy circuits**

Halbleiterspeichergerät mit Redundanzschaltungen

Dispositif de mémoire à semi-conducteurs avec circuits de redondance

(84) Designated Contracting States:
**DE FR GB NL**

(30) Priority: **10.01.1989 JP 3159/89**

(43) Date of publication of application:
**18.07.1990 Bulletin 1990/29**

(73) Proprietor: **Matsushita Electronics Corporation
Kadoma-shi, Osaka 571 (JP)**

(72) Inventors:
• **Hatta, Minoru
Takatsuki-shi, Osaka (JP)**
• **Hatta, Junko
Ibaraki-shi,Osaka (JP)**

(74) Representative: **Crawford, Andrew Birkby et al
A.A. THORNTON & CO.
Northumberland House
303-306 High Holborn
London WC1V 7LE (GB)**

(56) References cited:
**EP-A- 0 085 386          WO-A-83/02847
FR-A- 2 611 301          US-A- 4 573 146**

## Description

The present invention relates to a semiconductor memory device comprising a memory cell array having plural memory cells arranged in matrix, and plural I/O data lines, and more particularly to its redundancy circuits.

The advancement of degree of integration of semiconductor memory is notable, and in a dynamic random access memory (DRAM), the capacity of 1M bit is in the mainstream. In such large capacity random access memory, redundancy circuits are generally provided in order to lower the manufacturing cost. They are intended to dispose spare memory cells aside from the regular memory cells on the memory chip, and if defect is found in part of the regular cells in wafer inspection, replace them with the spare memory cells, thereby rescuing the defective chips of small bits. Practically, within the memory array having plural memory cells arranged in matrix, a spare row or a spare column for replacing the row or column containing defective memory cells, or both of them are provided, and when the row address or column address of the row or column containing defective memory cells is selected, the row or column in the regular memory cell array is not selected, but the spare row or spare column is selected.

As another tendency accompanying the advancement of the degree of integration of semiconductor memory, diversification of bit organization is known. Conventionally, the DRAMs were used in a huge quantity as the main memory of a computer, it was enough with the ×1 bit organization for accessing one memory cell each time. However, as the cost per bit is lowered, the application fields of DRAM have been expanded, and the number of memory cells that can be integrated on one chip is extremely increased, and hence there is a growing demand for the multi-bit DRAM for accessing several memory cells at a time. As the multi-bit memory, at the present, the ×4 bit organization is common in the DRAM, and the ×8 bit organization in the static random access memory (SRAM), but henceforth it is expected that memories of ×16 bit organization, ×32 bit organization and even ×64 bit organization will be required.

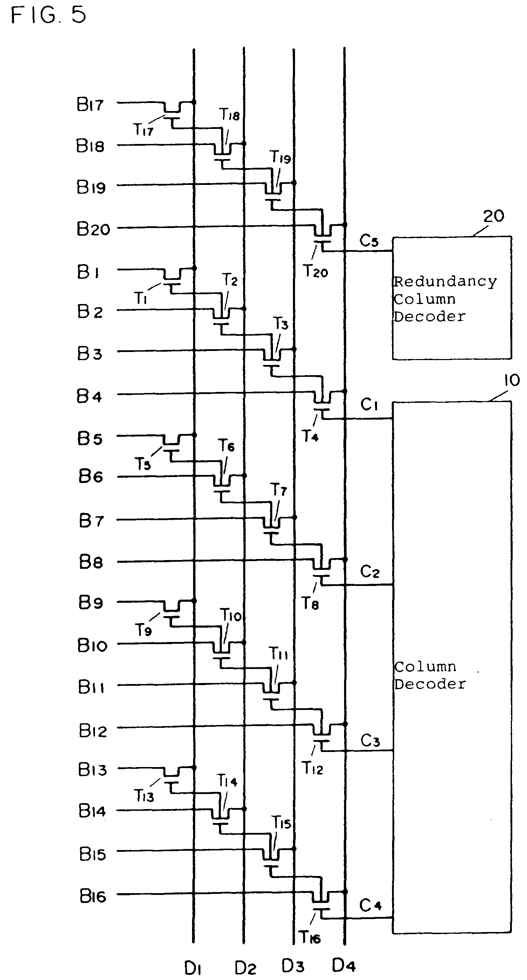

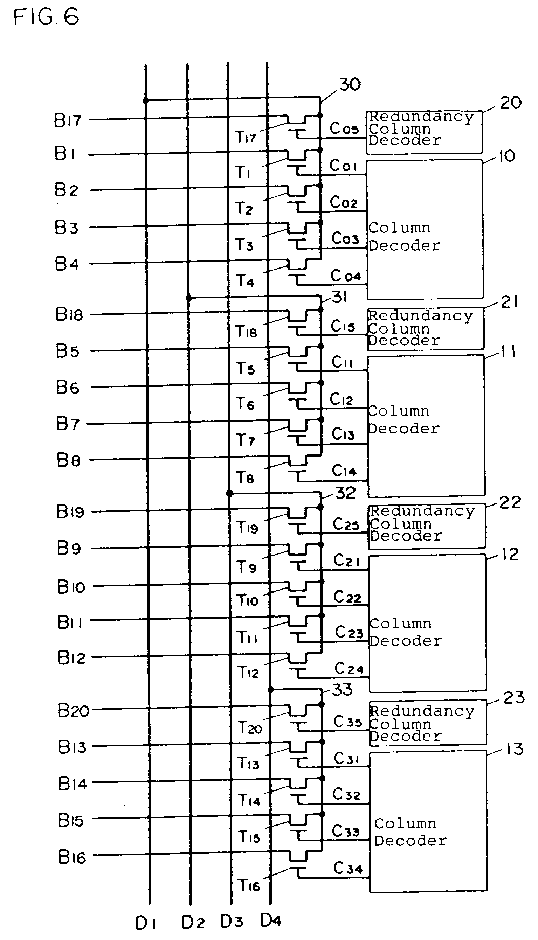

Examples of application of conventional redundancy circuits in such multi-bit memory device are shown in Figs. 5 and 6. For the sake of simplicity, in Figs. 5 and 6, the number of column addresses is four in ×4 bit organization. Besides, the column lines and I/O data lines are actually composed of a pair of two lines including the line for complementary data, but they are expressed by one line in these examples.

In Fig. 5, bit lines (column lines) possessing common column addresses are disposed adjacently. The bit lines B1, B2, ..., B16 are regular bit lines. D1, D2, D3, D4 are I/O data lines corresponding to each one of input, output data 4 bits. Transistors T1, T2, ..., T16 electrically connect the regular bit lines B1 to B16 to I/O data lines D1 to D4, according to the column selection signal lines C1, C2, C3, C4 decoded and activated by a regular column decoder 10. B17, B18, B19, B20 are spare bit lines, and if there is any defect in the memory cell on any of the regular bit lines B1 to B16 electrically connectable to the I/O data lines D1 to D4, such defective bit lines are replaced by spare bit lines B17 to B20. A redundancy column decoder 20 activates the redundancy column selection signal line C5 when the column address including the defective memory cell is selected. As a result, the transistors T17, T18, T19, T20 are made to conduct, and the spare bit lines B17 to B20 are electrically connected to the I/O data lines D1 to D4. At the same time, the column selection signal line to be activated by this column address if there is no defect in the regular memory cells remains inactive. The column address for activating the redundancy column selection signal line is set up by cutting off part of the fuse preliminarily formed on the chip by laser after discovering the defective memory cell in wafer inspection.

Fig. 6 is an example in which the bit lines electrically connected to the same I/O data line are disposed adjacently. As shown in Fig. 6, the regular bit lines B1, B2 ..., B16 are disposed as being divided into four blocks for every corresponding I/O data line. In this case, the column decoders 10, 11, 12, 13 are disposed in each block, and according to the column address, one from each block of column selection signal lines C01, C02, C03, C04, C11, C12, C13, C14, C21, C22, C23, C24, C31, C32, C33, C34, for example, the column selection signal lines C01, C11, C21, C31 are activated. Spare bit lines B17, B18, B19, B20, and redundancy column decoders 20, 21, 22, 23 are also disposed by one in each block. When the column address of the defective memory cell is selected, all of redundancy column selection signal lines C05, C15, C25, C35 are activated, and the transistors T17, T18, T19, T20 are made to conduct, and the spare bit lines B17, B18, B19, B20 are electrically connected to the I/O data lines D1, D2, D3, D4 respectively. At the same time, in each column decoder 10 to 13, the column selection signal line to be activated by the column address if there is no defect in the regular memory cells remains inactive.

Incidentally, the status of occurrence of defective memory cell is not completely random, but often adjacent memory cells become defective at the same time, or the adjacent bit lines are short-circuited to make two columns defective simultaneously. On the other hand, in the column redundancy circuit shown in Fig. 6, one bit line is replaced by the redundancy bit line in each block, and therefore if the adjacent upper and lower memory cells become defective at the same time, or the adjacent bit lines are short-circuited to be defective, it is impossible to rescue them. Hence, in the case of example shown in Fig. 6, it is disadvantageous that the efficiency of repair with the redundancy circuit is not raised so high.

By contrast, in Fig. 5, even if defective memory cells are present, spreading over two or more columns, it is advantageous that it is possible to replace with spare bit lines as far as in the range of same column address. In the case of Fig. 5, however, since the transfer gate transistors T1, T2, ... T20 for electrically connecting the bit lines to I/O data lines are disposed as being overlapped with the I/O data lines D1 to D4, the layout design is restricted, and the chip area is larger than in Fig. 6. Instead of forming the transistors beneath the I/O data line wiring region, it may be considered to connect the drains of the transistors T1 to T20 to the I/O data lines D1 to D4 with the wiring crossing the I/O data lines D1 to D4, but in the case of Fig. 5, if so structured, it is necessary to dispose one cross wiring for each bit line, and the wiring capacitance of the I/O data lines D1 to D4 increases significantly as compared with the case in which only one cross wiring is enough for each block, and the operating speed may be significantly lowered. Such problems of increase of chip area and reduction of operating speed become more and more serious when the number of bits of the input, output data increases.

In order to solve the above problems, the invention is intended to compose a redundancy circuit so as to replace the bit lines to be electrically connected to a specific I/O data line with the spare bit lines, instead of replacing the bit lines having a specific column address with spare bit lines, while maintaining the same circuit and composition as in Fig. 6 for the regular memory cells because it is advantageous in layout. In other words, if there is a column having defects, all bit lines sharing the I/O data line with such column are isolated from the I/O data line regardless of the column address, and, instead, a group of spare bit lines being disposed corresponding to each column address and selected according to the column address is electrically connected to the same I/O data line.

The present invention provides a semiconductor memory device comprising:

a memory cell array having plural memory cells arranged in rows and columns, having N (N being an integer not less than 2) columns in each one of M (M being an integer not less than 2) column addresses in the memory cell array the columns being arranged in N column blocks, each column block comprising M columns of different column addresses disposed adjacently;
N I/O data lines each correspond-ing to one of said N column blocks;
first electric connecting means for electrically connecting for each selected address said N I/O data lines to said N columns possessing selected address, such that each I/O data line is connected to a column in the corresponding column block according to said column addresses;
plural spare columns which can replace the columns in a column block of said memory cell array, with at least one spare column corresponding to each one of said M column addresses;
electric separating means arranged to inhibit the application of signals on at least one specific I/O data line out of said N I/O data lines to the columns electrically connected to said specific I/O data line; and
second electric connecting means for connecting the spare columns to said specific I/O data line according to said column addresses.

The invention also provides a semiconductor memory device according to a further embodiment, as claimed in claim 7.

According to this construction, the bit lines are disposed by dividing into each corresponding I/O data line, and if there are defects over two or more adjacent columns, as far as they are within the block of same I/O data line, all defective memory cells may be replaced by the memory cells of the spare column. Therefore, while minimizing the increase of chip area and reduction of operating speed due to multi-bit organization, a redundancy circuit high in the efficiency of repair may be realized.

Fig. 1 is a circuit diagram of a semiconductor memory device according to a first embodiment of the invention,

Fig. 2 is a circuit diagram of a semiconductor memory device according to a second embodiment of the invention,

Fig. 3 is a circuit diagram of a semiconductor memory device according to a third embodiment of the invention,

Fig. 4 is a circuit diagram of a semiconductor memory device according to a fourth embodiment of the invention, and

Fig. 5, Fig. 6 are circuit diagrams of conventional semiconductor memory devices.

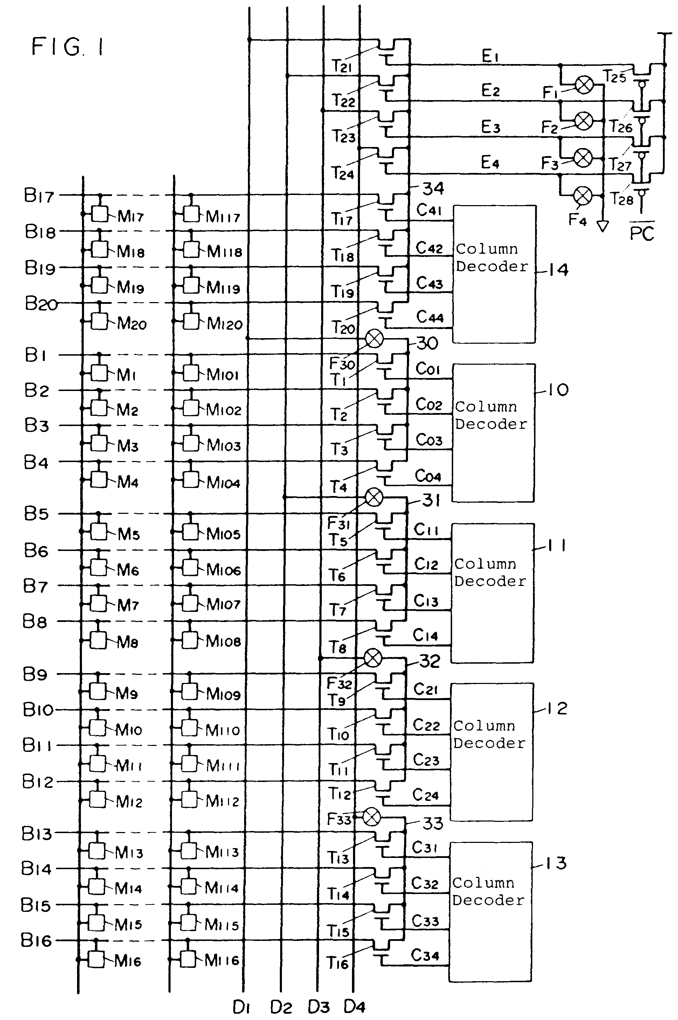

A first embodiment of multi-bit organized semiconductor memory of the invention is shown in Fig. 1. In Fig. 1, too, same as in Fig. 5, Fig. 6, the explanation is simplified by presenting a ×4 bit organization with four column addresses. In Fig. 1, the bit lines B1, B2 ..., B16 are divided into four blocks according to each corresponding I/O data line, and four bit lines corresponding to each one of four column addresses are disposed in each block. Regular memory cells M1 to M116 are connected to the bit lines B1 to B16 as shown in Fig. 1. Therefore, when a certain column address is selected, by column decoders 10, 11, 12, 13 disposed in each block, one from each block of column selection signal lines C01, C02, C03, C04, C11, C12, C13, C14; C21, C22, C23, C24, C31, C32, C33, C34, for example, column selection signal lines C01, C11, C21, C31 are selected and activated. As a result, of the transfer gate transistors T1, T2, ..., T16, the transistors T1, T5, T9, T13 having the activated column selection signal lines connected to their gates are made to conduct, and the bit lines B1, B5, B9, B13 are electrically connected to the block I/O data lines 30, 31, 32, 33. The block I/O data lines 30, 31, 32, 33 are electrically connected with I/O data lines D1, D2, D3, D4 respectively through fuses F30, F31, F32, F33.

B17, B18, B19, B20 are spare bit lines, one each corresponding to the four column addresses, totaling to four, same as in one block of the regular bit lines B1 to B16. Spare memory cells M17 to M120 are connected to the spare bit lines B17 to B20 as shown in Fig. 1. The block of the spare bit lines B17 to B20 also possesses a column decoder 14, and when a certain column address is selected, one of the column selection signal lines C41, C42, C43, C44 is, for example column selection signal line C41 is selected. In consequence, of the transfer gate transistors T17, T18, T19, T20, the transistor T17 connected with the column selection signal line C41 at its gate is made to conduct, and the spare bit line B17 is electrically connected to the block I/O data line 34 in the spare bit line block.

In the regular bit lines, if defects are found in the memory cells (e.g. M1, M101) electrically connected to, for example, bit line B1, the fuse F30 connecting between the I/O data line D1 and block I/O data line 30 is blown off by laser beam radiation. As a result, the regular memory cells (e.g. M1, M101) are not electrically connected to the I/O data line D1. Instead, accordingly, the fuse F1 is blown off, and of the transfer gate transistors T21, T22, T23, T24, the transistor T21 between the I/O data line D1 and the block I/O data line 34 in spare block is made to conduct, while the other transistors T22, T23, T24 are kept in non-conducting state. Thus, the block of the bit lines B1, B2, B3, B4, including the bit line B1 having defective memory cells is replaced by the block of spare bit lines B17, B18, B19, B20, so that this memory chip can operate normally on the whole. The gate potentials E1, E2, E3, E4 of the transistors T21, T22, T23, T24 electrically connecting selectively between the block I/O data line 34 in spare block and the I/O data lines D1, D2, D3, D4 are usually maintained at the ground level by the fuses F1 to F4, and the transistors T21, T22, T23, T24 are in non-conducting state. However, when the fuse F1 between the gate and ground of the transistor T21 is blown off, the gate potential E1 of the transistor T21 is precharged to the supply voltage level when the transistor T25 is made to conduct by the precharge signal $\overline{PC}$ during the precharge period of memory, and this voltage is maintained thereafter, so that the transistor T21 is always in conducting state. As a result, the spare bit lines B17, B18, B19, B20 are electrically connected to the I/O data line D1 through the transfer gate transistor T21 which is controlled by the column selection transfer gate transistors T17, T18, T19, T20, and fuse F1 according to the column address, so as to replace the bit lines B1, B2, B3, B4 containing defective memory cells.

In the foregoing explanation, it is supposed that there are defects in the memory cells electrically connected to the bit line B1, but if there are defective memory cells in the bit line B2, B3 or B4, or in two or more of them, quite similarly, the defective bit lines may be replaced by the spare bit lines by blowing off the fuses F1 and F30, so that a memory chip operating normally may be obtained. More generally speaking, whichever of the regular bit lines B1, B2, ..., B16 may be defective, as far as the defects are limited within one block, the defects may be repaired by blowing off two proper fuses.

As clear from the description herein, according to the first embodiment of the invention, while the memory cell array of multi-bit organized semiconductor memory device is arranged by dividing into blocks in each bit group of input, output data having the layout advantage, it is possible to obtain a redundancy circuit high in the repair efficiency capable of repairing defects occurring in plural columns which occur at high incidence. In the conventional method of replacing the bit lines of specific column address, the repair efficiency may be enhanced by replacing the plural column address with spare bit lines in each block. If thus composed, however, since plural spare bit lines may be provided in each block, the chip size increases and finally the manufacturing cost is raised. In particular, when the number of bits of input, output data is similar to or superior to the number of column addresses, the chip area is smaller and the defect repair efficiency is higher by employing the redundancy circuit of the invention, and the manufacturing cost is significantly lowered.

Incidentally, in the embodiment in Fig. 1, fuses F1 to F4 are connected between the gate electrodes of the transfer gate transistors T21 to T24 and ground. When one of these fuses is blown off, a supply voltage Vcc is applied to the gate electrode of the transistor corresponding to that fuse, and this transistor is made to conduct, thereby connecting the bit line and data line.

In such construction, however, the gate potential of the transistor in conductive state is in floating state, and it is susceptible to the effects of noise.

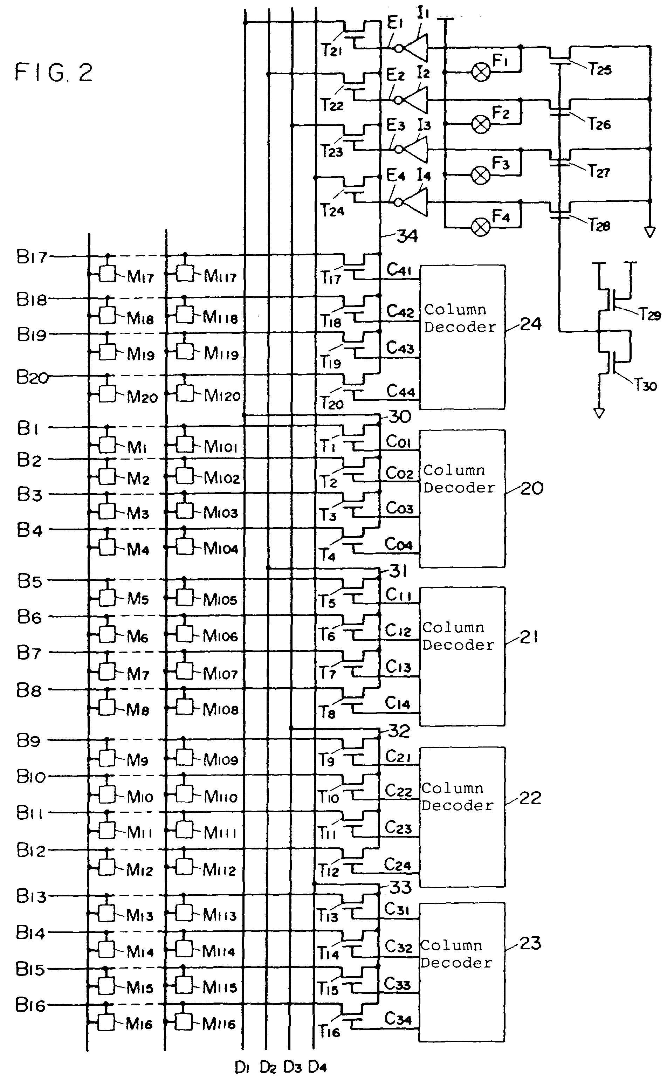

Fig. 2 shows a second embodiment of the invention intended to solve such a problem.

In Fig. 2, those same as in Fig. 1 are identified with the same reference numbers and are not particularly explained herein, and only the different parts from Fig. 1 are described in detail.

In Fig. 2, a voltage generator circuit composed of transistors T29, T30 generates a voltage slightly higher than the threshold voltage of the transistor. Since this voltage is applied to the gate electrode of the transistors T25 to T28, the transistors T25 to T28 possess a high resistance. Inverters I1 to I4 are connected between the drain electrodes of the transistors T25 to T28 and the transfer gate transistors T21 to T24. Fuses F1 to F4 are connected between the drain electrodes of the transistors T25 to T28, and the supply voltage Vcc.

The operation in Fig. 2 is explained below.

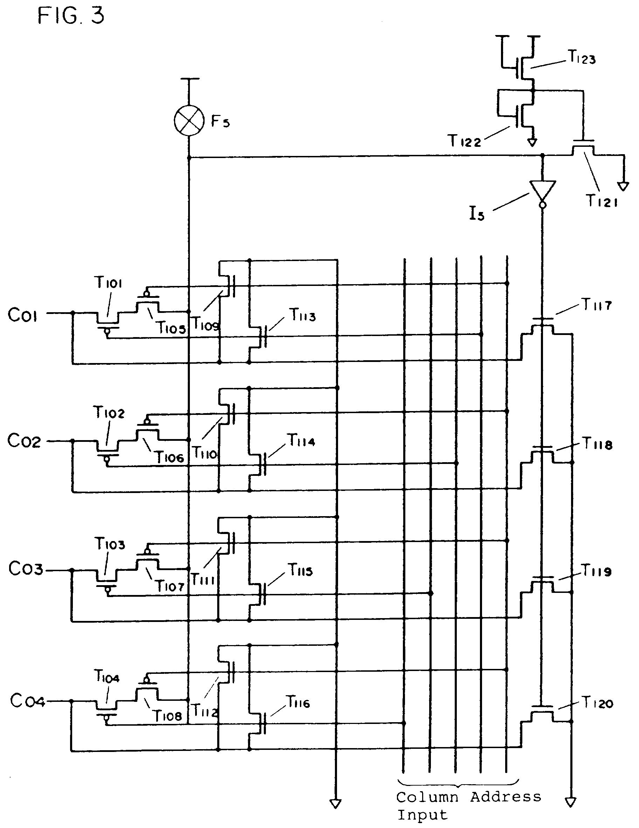

While there is no defect in the regular memory cells M1 to M116, all fuses F1 to F4 are connected. Accordingly, the input side potential of the inverters I1 to I4 in Fig. 3 is nearly equal to the supply voltage Vcc. Therefore, the gate potentials E1 to E4 of the transistors T21 to T24 are ground potentials, and the transistors T21 to T24 are in non-conducting state, and the redundancy circuit does not operate.

On the other hand, if there are defects in any of the regular memory cells M1 to M116, for example, the memory cells M1, M101 connected to the bit line B1 are defective, the fuse F1 shown in Fig. 2 is blown off. When this fuse F1 is blown off, the input side potential of the inverter I1 comes to the ground level, and the output potential of the inverter I1 becomes nearly equal to the supply voltage Vcc, so that the transfer gate transistor T21 is made to conduct. Accordingly, the block of the bit lines B1, B2, B3, B4 including the bit line B1 containing the defective memory cells M1, M101 is replaced by the block of spare bit lines B17, B18, B19, B20, so that the memory device can operate normally on the whole.

Thus, according to the second embodiment of the invention, when any one of the fuses F1 to F4 is blown off, the gate electrode of the corresponding one of the transfer gate transistors T21 to T24 is connected to the ground by way of the inverters I1 to I4 and transistors T25 to T28. In other words, the gate potentials of the transfer gate transistors T21 to T24 are fixed at a specific potential at high level. Accordingly, the gate potentials will not be in floating state as experienced in the embodiment in Fig. 1, so that a stable operation less influenced by the noise may be expected.

Meanwhile, in the embodiment in Fig. 1, it is designed to select the bit lines connected to the left side of each column decoder by the column decoders 10 to 14, while in the actual memory device, sometimes, the same bit lines and memory cells as those shown at the left side of the column decoders 10 to 14 are symmetrically connected also at the right side of the column decoders 10 to 14. In such memory device, as shown in the embodiment in Fig. 1, when fuses F30, F31, F32, F33 are connected correspondingly to the column decoders, the fuses must be disposed at both right and left sides of the column decoders, and the number of fuses increases. Besides, in the construction in Fig. 1, since the fuses F30 to F33 are connected to the block I/O data lines 30 to 33, the electric characteristic of the memory device is likely to be influenced by the fuses F30 to F33.

Fig. 3 shows a third embodiment of the invention to solve such problem. Fig. 3 shows the internal structure of one column decoder (the column decoder 20 in Fig. 2).

In Fig. 3, transistors T101 to T116 compose a column decoder circuit. Column selection signal lines C01 to C04 are connected to the ground through transistors T117 to T120. A voltage generator circuit composed of transistors T122, T123 generates a voltage slightly higher than the threshold voltage of the transistor. Since this voltage is applied to the gate electrode of the transistor T121, the transistor T121 has a high resistance. A fuse F5 is connected between the column decoder circuit and transistor T121 and supply voltage Vcc. The drain potential of the transistor T121 is applied to the gate electrodes of the transistors T117 to T120 through inverter I5.

The operation of Fig. 3 is explained.

If there is no defect in the regular memory cells, the fuse F5 is connected. Accordingly, the input side potential of the inverter I5 is nearly equal to the supply voltage Vcc, and the output potential of the inverter I5 is the ground level. Therefore, all transistors T117 to T120 are in non-conducting state.

On the other hand, if there is defect in the regular memory cells, the fuse F5 is blown off. As a result, the input side potential of the inverter I5 becomes nearly equal to the ground level, and the output potential of the inverter I5 becomes nearly equal to the supply voltage. Consequently, all of transistors T117 to T120 are in conducting state, and all column selection signal lines C01 to C04 are set to the ground level in batch, regardless of the column address having defective memory cells. As a result, all transfer gate transistors T1 to T4 for connecting the bit lines B1 to B4 to the I/O data line D1 corresponding to the row decoder 20 are set in non-conducting state.

Thus, according to the embodiment in Fig. 3, the fuse F5 is connected between the column decoder circuit and power supply, and is not connected to the block I/O data line. Accordingly, the electric characteristic of the memory device is not influenced by the fuse F5. Besides, when circuits symmetrical to the memory cells, bit lines and column selection lines shown in Fig. 2 are further connected at the right side, and it is designed to select the right and left bit lines by one column decoder, the right and left bit lines may be electrically cut off at a time only by installing one common fuse F5.

Incidentally, as a special memory device for image processing, it is considered to use two kinds of column addresses, feed plural data bits by using first column addresses, and specify the bits of the data by the second column addresses. In such a memory device, when the conventional method is applied to the first column address, that is, when the redundancy circuit is designed to replace the columns having a specific column address with spare columns, the spare columns must have all the column addresses, one for each column, as to the second column addresses, and it was impossible in the conventional method to realize the column redundancy circuit functioning effectively to either column address.

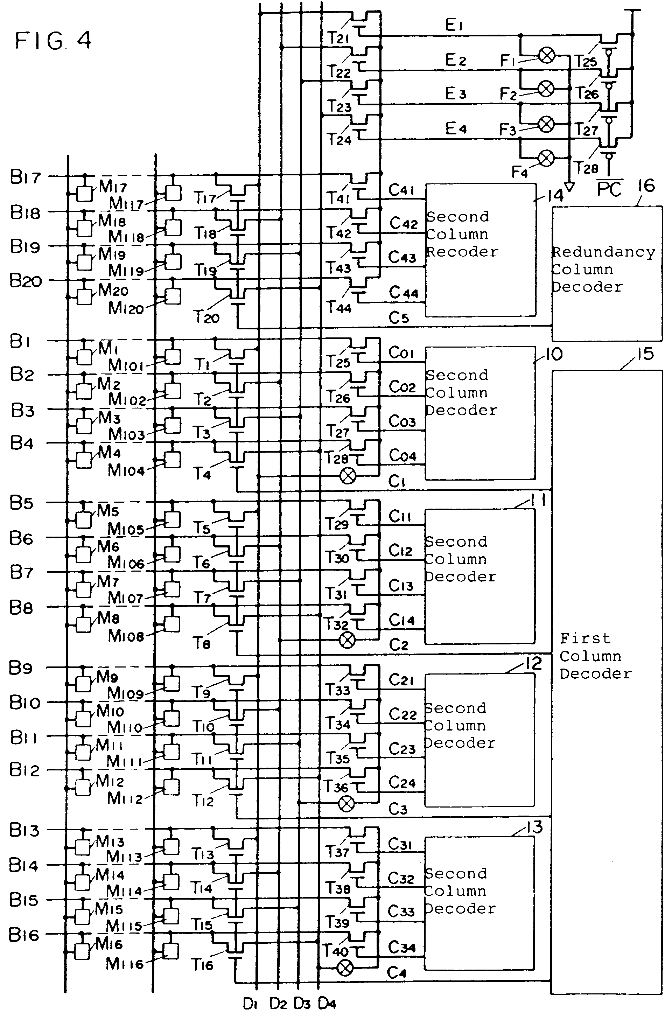

Fig. 4 shows a fourth embodiment of the invention for solving such a problem.

Fig. 4 is a combination of the conventional redundancy circuit shown in Fig. 5 and the redundancy circuit of the first embodiment shown in Fig. 1.

The first column addresses are fed to a first column decoder 15. Concerning these first column addresses, a redundancy circuit using a redundancy column decoder 16 is realized. This is the same as the conventional redundancy circuit shown in Fig. 5. The second column addresses are fed to the second column decoders 10, 11, 12, 13. Concerning these second column addresses, the circuit shown in the upper part of Fig. 4, that is, the same redundancy circuit as in the embodiment in Fig. 1 is added.

Thus, according to the embodiment in Fig. 4, it is possible to add redundancy circuit to an application specific memory device possessing two kinds of column addresses.

Meanwhile, the redundancy circuit portion of the embodiment in Fig. 4, may be replaced by the redundancy circuit shown in the embodiment in Fig. 2, or, needless to say, the internal structure of the second column decoders 10 to 14 in the embodiment in Fig. 4 may be constructed same as in the embodiment in Fig. 3.

## Claims

1. A semiconductor memory device comprising:

   a memory cell array having plural memory cells ($M_1$,...., $M_{16}$, $M_{101}$,...., $M_{116}$) arranged in rows and columns, having N (N being an integer not less than 2) columns in each one of M (M being an integer not less than 2) column addresses in the memory cell array, the columns being arranged in N column blocks, each column block comprising M columns of different column addresses disposed adjacently;
   N I/O data lines ($D_1$,..., $D_4$) each correspond-ing to one of said N column blocks;
   first electric connecting means ($T_1$,..., $T_{16}$) for electrically connecting for each selected address said N I/O data lines to said N columns possessing selected address, such that each I/O data line is connected to a column in the corresponding column block according to said column addresses;
   plural spare columns which can replace the columns in a column block of said memory cell array, with at least one spare column corresponding to each one of said M column addresses;
   electric separating means ($F_{30}$,...,$F_{33}$;$F_5$) arranged to inhibit the application of signals on at least one specific I/O data line out of said N I/O data lines ($D_1$,...,$D_4$) to the columns electrically connected to said specific I/O data line; and
   second electric connecting means for connecting the spare columns to said specific I/O data line according to said column addresses.

2. A semiconductor memory device according to claim 1, wherein said electric separating means is arranged to electrically separate said at least one specific I/O data line from the columns electrically connected thereto.

3. A semiconductor memory device according to claim 1, wherein said electric separating means and said second electric connecting means respectively comprise fusible links.

4. A semiconductor memory device according to claim 1, wherein said second electric connecting means comprises:

   N transfer gate transistors ($T_{21}$,....,$T_{24}$) for connecting said spare columns to an arbitrary one of said N I/O data lines ($D_1$,...,$D_4$) according to said column addresses;
   means ($T_{25}$,....,$T_{28}$) for applying a certain voltage to the gate electrodes of said transfer gate transistors; and
   N fusible links ($F_1$,...,$F_4$) connected between said gate electrodes of said transfer gate transistors and reference potential point.

5. A semiconductor memory device according to claim 1, wherein said second electric connecting means comprises:

   N transfer gate transistors ($T_{21}$,...,$T_{24}$) for connecting said spare columns to an arbitrary one of said N I/O data lines according to said column addresses,
   means for applying a certain voltage to the gate electrodes of said transfer gate transistors through inverters ($I_1$,...,$I_4$);
   N fusible links ($F_1$,...,$F_4$) connected between said input end of said each inverter and the reference potential point.

6. A semiconductor memory device according to claim 1, wherein the electric separating means comprises:

   fusible links ($F_5$) having at least one corresponding to each one of the I/O data lines; and
   means for fixing the column selection signal line relating to a specific I/O data line in an inactive state regardless of said column address, by blowing off said fusible link ($F_5$) relating to the specific I/O data line.

7. A semiconductor memory device comprising:

   a memory cell array having plural memory cells ($M_1$,...,$M_{16}$,$M_{101}$,...,$M_{116}$) arranged in rows and columns, in which first and second column addresses are assigned to NxN (N being an integer not less than 2) columns in the memory cell array, the first column addresses specifying N batches of N columns, and the second column addresses also specifying N batches of N columns, there being in each batch specified by one of said second column addresses, one of N columns specified by each of said first column addresses, the columns being arranged such that columns having the same first column address are disposed adjacently;
N I/O data lines $(D_1,...,D_4)$;
first electric connecting means $(T_1,...,T_{16})$ for electrically connecting said N I/O data lines to N columns possessing a selected first column address according to the first column addresses;
second electric connecting means $(T_{25},...,T_{40})$ for electrically connecting said N I/O data lines to N columns possessing a selected second column address according to the second column address;
at least N spare columns that can replace part of the columns of said memory cell array;
third electric connecting means $(T_{17},....,T_{20})$ for electrically connecting said spare columns one by one to said N I/O data lines, functioning instead of said first electric connecting means, when a specific one of said first column addresses is input;
electric separating means arranged to inhibit the application of signals on at least one specific I/O data line out of said N I/O data lines to the columns in said memory cell array electrically connected to the specific I/O data line;
fourth electric connecting means for connecting said spare columns to said specific I/O data line according to said second column addresses.

8. A semiconductor memory device according to claim 7, wherein said electric separating means is arranged to electrically separate said at least one specific I/O data line from the columns electrically connected thereto.

9. A semiconductor memory device according to claim 7, wherein said electric separating means and said fourth electric connecting means respectively comprise fusible links.

10. A semiconductor memory device according to claim 7, wherein said fourth electric connecting means comprises:

N transfer gate transistors for connecting said spare columns to an arbitrary one of said I/O data lines according to said second column addresses;
means for applying a certain voltage to the gate electrodes of said transfer gate transistors; and
N fusible links connected between said gate electrodes of said transfer gate transistors and reference potential point.

11. A semiconductor memory device according to claim 7, wherein said fourth electric connecting means comprises:

N transfer gate transistors for connecting said spare columns to an arbitrary one of said N I/O data lines according to said second column addresses,
means for applying a certain voltage to the gate electrodes of said transfer gate transistors through inverters;
N fusible links connected between the input end of said each inverter and the supply potential point; and
N high resistance elements connected between said input end of said each inverter and the reference potential point.

12. A semiconductor memory device according to claim 7, wherein the electric separating means comprises:

fusible links having at least one corresponding to each of the I/O data lines; and
means for fixing the column selection signal line relating to a specific I/O data line in an inactive state regardless of said column addresses, by blowing off said fusible link relating to the specific I/O data line.

**Patentansprüche**

1. Eine Halbleiter-Speichereinrichtung umfassend:

Eine Speicherzellen-Vielfachanordnung, die eine Vielzahl von Speicherzellen $(M_1,....,M_{16},M_{101},....,M_{116})$ aufweist, die in Zeilen und Spalten angeordnet sind, wobei sie N (N ist eine ganze Zahl von nicht weniger als 2) Spalten in jeder von M (M ist eine ganze Zahl nicht weniger als 2) Spaltenadressen in der Speicherzellen-Mehrfachanordnung aufweist, wobei die Spalten in N Spaltenblöcken angeordnet sind, jeder Spaltenblock M Spalten unterschiedlicher Spaltenadressen umfaßt, die benachbart angeordnet sind;

N Eingangs/Ausgangs-Datenleitungen $(D_1,...,D_4)$ von denen jede einem der genannten N Spaltenblöcke entspricht;

eine erste, elektrische Verbindungseinrichtung $(T_1,..,T_{16})$ zum elektrischen Verbinden der genannten N Eingangs/Ausgangs-Datenleitungen für jede augewählten Adresse mit den genannten N Spalten, die die ausgewählte Adresse besitzen, so daß jede Eingangs/Ausgangs-Datenleitung mit einer Spalte in dem entsprechenden Spaltenblock nach Maßgabe der genannten Spaltenadressen verbunden ist;

mehrere Ersatzspalten, die die Spalten in einem Spaltenblock der genannten Speicherzellen-Mehrfachanordnung ersetzen können, wobei mindestens eine Ersatzspalte jeder der genannten M Spaltenadressen entspricht;

eine elektrische Trenneinrichtung $(F_{30},...,F_{33};F_5)$, die angeordnet ist, das Anwenden von Signalen auf mindestens einer bestimmte Eingabe/Ausgabe-Datenleitung von den genannten N Eingangs/Ausgangs-Datenleitungen $(D_1,...,D_4)$ auf die Spalten zu sperren, die elektrisch mit der genannten bestimmten Eingangs/Ausgangs-Datenleitung verbunden sind; und

eine zweite, elektrische Verbindungseinrichtung zum Verbinden der Ersatzspalten mit der genannten bestimmten Eingangs/Ausgangs-Datenleitung nach Maßgabe der genannten Spaltenadressen.

2. Eine Halbleiter-Speichereinrichtung gemäß Anspruch 1, in der die genannte elektrische Trenneinrichtung ausgebildet ist, elektrisch die genannte mindestens eine bestimmte Eingangs/Ausgangs-Datenleitung von den Spalten zu trennen, die damit elektrisch verbunden sind.

3. Eine Halbleiter-Speichereinrichtung gemäß Anspruch 1, in der die genannte elektrische Trenneinrichtung und die genannte zweite, elektrische Verbindungseinrichtung jeweils schmelzbare Verbindungen umfassen.

4. Eine Halbleiter-Speichereinrichtung gemäß Anspruch 1, in der die genannte zweite elektrische Verbindungseinrichtung umfaßt:

N Übertragungstortransistoren $(T_{21},...,T_{22})$ um die genannten Ersatzspalten mit einer beliebigen der genannten N Eingangs/Ausgangs-Datenleitungen $(D_1,...,D_4)$ nach Maßgabe der genannten Spaltenadressen zu verbinden;

eine Einrichtung $(T_{25},...,T_{28})$ zum Anwenden einer bestimmten Spannung auf die Gateelektroden der genannten Übertragungstortransistoren; und

N schmelzbare Verbindungen $(F_1,...,F_4)$, die zwischen den genannten Gateelektroden der genannten Übertragungstor-transistoren und dem Bezugspotentialpunkt verbunden sind.

5. Eine Halbleiter-Speichereinrichtung gemäß Anspruch 1, in der die genannte zweite, elektrische Verbindungseinrichtung umfaßt:

N Übertragungstortransistoren $(T_{21},...,T_{22})$ zum Verbinden der genannten Ersatzspalten mit einer beliebigen der genannten N Eingangs/Ausgangs-Datenleitungen nach Maßgabe der genannten Spaltenadressen;

eine Einrichtung zum Anlegen einer bestimmten Spannung an die Gateelektroden der genannten Übertragungstortransistoren durch Umkehreinrichtungen $(I_1,...,I_4)$;

N schmelzbare Verbindungen $(F_1,...,F_4)$, die zwischen dem genannten Eingangsende von jeder genannten Umkehreinrichtung und dem Bezugspotentialpunkt verbunden sind.

6. Eine Halbleiter-Speichereinrichtung gemäß Anspruch 1, in der die elektrische Trenneinrichtung umfaßt:

Schmelzbare Verbindungen $(F_5)$, die mindestens eine aufweisen, die jeder der Eingangs/Ausgangs-Datenleitungen entspricht; und

eine Einrichtung zum Festlegen der Spaltenauswählsignalleitung, die sich auf eine bestimmte Eingangs/Ausgangs-Datenleitung in einem inaktiven Zustand ohne Rücksicht auf die genannte Spaltenadresse bezieht, indem die genannte schmelzbare Verbindung $(F_5)$ geschmolzen wird, die sich auf die bestimmte Eingangs/Ausgangs-Datenleitung bezieht.

7. Eine Halbleiter-Speichereinrichtung umfassend:

Eine Speicherzellen-Mehrfachanordnung, die eine Vielzahl von Speicherzellen $(M_1,...,M_{16},M_{101},...,M_{116})$ aufweist, die in Zeilen und Spalten angeordnet sind, wobei erste und zweite Spaltenadressen NxN (N ist eine ganze Zahl von nicht weniger als 2) Spalten in der Speicherzellen-Mehrfachanordnung zugeordnet sind, die ersten Spaltenadressen N Gruppen von N Spalten festlegen, und die zweiten Spaltenadressen N Gruppen von N Spalten festlegen, wobei in jeder der durch eine der genannten zweiten Spaltenadressen festgelegten Gruppe eine der N Spalten vorliegt, die durch jede der genannten ersten Spaltenadressen bestimmt sind, wobei die Spalten so angeordnet sind, daß Spalten, die die gleiche erste Spaltenadresse haben, benachbart angeordnet sind;

N Eingangs/Ausgangs-Datenleitungen $(D_1,...,D_4)$;

eine erste, elektrische Verbindungseinrichtung $(T_1,...,T_{16})$ zum elektrischen Verbinden der genannten N Eingangs/Ausgangs-Datenleitungen mit N Spalten, die eine ausgewählte, erste Spaltenadresse gemäß den ersten Spaltenadressen besitzt;

eine zweite, elektrische Verbindungseinrichtung $(T_{25},...,T_{40})$ zum elektrischen Verbinden der genannten N Eingangs/Ausgangs-Datenleitungen mit N Spalten, die eine ausgewählte, zweite Spaltenadresse gemäß der zweiten Spaltenadresse besitzt;

mindestens N Ersatzspalten, die einen Teil der Spalten der genannten Speicherzellen-Mehrfachanordnung ersetzen können;

eine dritte, elektrische Verbindungseinrichtung $(T_{17},...,T_{20})$ zum elektrischen Verbinden der genannten Ersatzspalten einzeln mit den genannten N Eingangs/Ausgangs-Datenleitungen, die statt der genannten ersten, elektrischen Verbindungseinrichtung funktionieren, wenn eine bestimmte der genannten ersten Spaltenadressen eingegeben wird;

eine elektrische Trenneinrichtung, die ausgebildet ist, das Anlegen von Signalen auf mindestens einer bestimmten Eingangs/Ausgangs-Datenleitung von den genannten N Eingangs/Ausgangs-Datenleitungen an die Spalten in der genannten Speicherzellen-Mehrfachanordnung hindert, die elektrisch mit der bestimmten Eingangs/Ausgangs-Datenleitung verbunden sind;

eine vierte, elektrische Verbindungseinrichtung zum Verbinden der genannten Ersatzspalten mit der genannten bestimmten Eingangs/Ausgangs-Datenleitung nach Maßgabe der genannten zweiten Spaltenadressen.

8. Eine Halbleiter-Speichereinrichtung gemäß Anspruch 7, in der die genannte elektrische Trenneinrichtung ausgestaltet ist, elektrisch die genannte mindestens eine bestimmte Eingangs/Ausgangs-Datenleitung von den Spalten zu trennen, die elektrisch damit verbunden sind.

9. Eine Halbleiter-Speichereinrichtung gemäß Anspruch 7, in der die genannte elektrische Trenneinrichtung und die genannte vierte, elektrische Verbindungseinrichtung jeweils schmelzbare Verbindungen umfassen.

10. Eine Halbleiter-Speichereinrichtung gemäß Anspruch 7, in der die genannte vierte, elektrische Verbindungseinrichtung umfaßt:

N Übertragungstortransistoren zum Verbinden der genannten Ersatzspalten mit einer beliebigen der genannten Eingangs/Ausgangs-Datenleitungen nach Maßgabe der genannten zweiten Spaltenadressen;

eine Einrichtung zum Anlegen einer gewissen Spannung an die Gateelektroden der genannten Übertragungstortransistoren; und

N schmelzbare Verbindungen, die zwischen den genannten Gateelektroden der genannten Übertragungstortransistoren und dem Bezugspotentialpunkt verbunden sind.

11. Eine Halbleiter-Speichereinrichtung gemäß Anspruch 7, in der die genannte vierte, elektrische Verbindungseinrichtung umfaßt:

N Übertragungstortransistoren zum Verbinden der genannten Ersatzspalten mit einer beliebigen der genannten N Eingangs/Ausgangs-Datenleitungen nach Maßgabe der genannten zweiten Spaltenadressen;

eine Einrichtung zum Anlegen einer bestimmten Spannung an die Gateelektroden der genannten Übertragungstortransistoren durch Umkehrungseinrichtung;

N schmelzbare Verbindungen, die zwischen dem Eingangsende von jeder genannten Umkehreinrichtung und dem Versorgungspotentialpunkt verbunden sind; und

N Elemente mit hohem Widerstand, die zwischen dem genannten Eingangsende von jeder genannten Umkehreinrichtung und dem Bezugspotentialpunkt verbunden sind.

12. Eine Halbleiter-Speichereinrichtung gemäß Anspruch 7, in der die elektrische Trenneinrichtung umfaßt:

schmelzbare Verbindungen, von denen mindestens eine jeder der Eingangs/Ausgangs-Datenleitungen entspricht; und

eine Einrichtung zum Festlegen der Spaltenauswählsignalleitung, die sich auf eine bestimmte Eingangs/Ausgangs-Datenleitung, in einem inaktiven Zustand ohne Rücksicht auf die genannten Spaltenadressen bezieht, indem die genannte schmelzbare Verbindung getrennt wird, die sich auf die bestimmte Eingangs/Ausgangs-Datenleitung bezieht.

## Revendications

1. Dispositif de mémoire à semi-conducteur comprenant :

 - une configuration de cellules de mémoire possédant plusieurs cellules de mémoire ($M_1$, ..., $M_{16}$, $M_{101}$, ..., $M_{116}$) disposées en rangées et en colonnes, possédant N (N étant un entier non inférieur à 2) colonnes dans chacune de M (M étant un entier non inférieur à 2) adresses de colonne dans la configuration de cellules de mémoire, les colonnes étant agencées en N blocs de colonnes, chaque bloc de colonnes comprenant M colonnes de différentes adresses de colonne disposées de façon adjacente;
 - N lignes de données E/S ($D_1$, ..., $D_4$) correspondant chacune à un desdits N bloc de colonnes;
 - des premiers moyens de connexion électrique ($T_1$, ..., $T_{16}$) pour la connexion électrique, pour chaque adresse choisie, desdites N lignes de données E/S auxdites N colonnes possédant l'adresse choisie de telle façon que chaque ligne de données E/S soit raccordée à une colonne dans le bloc de colonnes correspondant selon lesdites adresses de colonne;
 - plusieurs colonnes de remplacement pouvant remplacer les colonnes dans un bloc de colonnes de ladite configuration de cellules de mémoire avec au moins une colonne de remplacement correspondant à chacune desdites M adresses de colonne;
 - des moyens de séparation électrique ($F_{30}$, ..., $F_{33}$; $F_5$) disposés pour empêcher l'application de signaux sur au moins une ligne spécifique de données E/S en dehors desdites M lignes de données E/S ($D_1$, ..., $D_4$) aux colonnes électriquement raccordées à ladite ligne spécifique de données E/S; et
 - un second moyen de connexion électrique pour raccorder les colonnes de remplacement à ladite ligne spécifique de données E/S selon lesdites adresses de colonne.

2. Dispositif de mémoire à semi-conducteur selon la revendication 1, dans lequel ledit moyen de séparation électrique est prévu pour séparer, de façon électrique, au moins une dite ligne spécifique de données E/S des colonnes électriquement raccordées.

3. Dispositif de mémoire à semi-conducteur selon la revendication 1, dans lequel ledit moyen de séparation électrique et ledit second moyen de raccordement électrique comprennent respectivement des liaisons fusibles.

4. Dispositif de mémoire à semi-conducteur selon la revendication 1, dans lequel ledit second moyen de connexion comprend :

 - N transistors à grille de transfert ($T_{21}$, ..., $T_{24}$) pour connecter lesdites colonnes de remplacement à une ligne arbitraire desdites N lignes de données E/S ($D_1$, ..., $D_4$) selon lesdites adresses de colonne;
 - des moyens ($T_{25}$, ..., $T_{28}$) pour appliquer une certaine tension aux électrodes de grille desdits transistors à grille de transfert; et
 - N liaisons fusibles ($F_1$, ..., $F_4$) montées entre lesdites électrodes de grille desdits transistors à grille de transfert et le point de potentiel de référence.

5. Dispositif de mémoire à semi-conducteur selon la revendication 1, dans lequel ledit second moyen de connexion électrique comprend :

 - N transistor à grille de transfert ($T_{21}$, ..., $T_{24}$) pour raccorder lesdites colonnes de remplacement à une ligne arbitraire desdites N lignes de données E/S selon lesdites adresses de colonne;
 - un moyen pour appliquer une certaine tension aux électrodes de grille desdits transistors à grille de transfert via des inverseurs ($I_1$, ..., $I_4$); et
 - N liaisons fusibles ($F_1$, ..., $F_4$) montées entre ladite extrémité d'entrée de chacun desdits inverseurs et le point de potentiel de référence.

6. Dispositif de mémoire à semi-conducteur selon la revendication 1, dans lequel le moyen de séparation électrique comprend :

 - des liaisons fusibles ($F_5$) ayant au moins une liaison correspondant à chacune desdites lignes de données E/S; et
 - un moyen pour fixer la ligne de signal de sélection de colonne concernant une ligne spécifique de données E/S dans un état inactif indépendamment de ladite adresse de colonne en coupant ladite liaison fusible ($F_5$) concernant la ligne spécifique de données E/S.

7. Dispositif de mémoire à semi-conducteur comprenant :

 - une configuration de cellules de mémoire possédant plusieurs cellules de mémoire ($M_1$, ..., $M_{16}$, $M_{101}$, ... $M_{116}$) disposées en rangées et en colonne, dans laquelle des premières et secondes adresses de colonne sont assignées à NxN (N étant un entier non inférieur à 2) colonnes dans la configuration de cellules de mémoire, les premières adresses de colonne spécifiant N lots de N colonnes, et les secondes adresses de colonne spécifiant, de même, N lots de N colonnes, une des N colonnes spécifiée par chacune desdites premières adresses de colonne se trouvant dans chaque lot spécifié par une desdites secondes adresses de colonne, les colonnes étant disposées de telle façon que des colonnes ayant la même première adresse de colonne soient disposées de façon adjacente;

- N lignes de données E/S ($D_1$, ..., $D_4$);
- des premiers moyens de connexion électrique ($T_1$, ... $T_{16}$) pour raccorder électriquement lesdites N lignes de données E/S aux N colonnes possédant une première adresse de colonne choisie selon les premières adresses de colonne;
- des seconds moyens de connexion électrique ($T_{25}$, ..., $T_{40}$) pour raccorder électriquement lesdites N lignes de données E/S aux N colonnes possédant une seconde adresse de colonne choisie selon les secondes adresses de colonne;
- au moins N colonnes de remplacement pouvant remplacer une partie des colonnes de ladite configuration de cellules de mémoire;
- des troisièmes moyens de connexion électrique ($T_{17}$, ..., $T_{20}$) pour raccorder électriquement lesdites colonnes de remplacement, une par une, auxdites N données E/S, fonctionnant à la place desdits premiers moyens de connexion électrique lorsqu'une adresse spécifique desdites premières adresses de colonne est entrée;
- un moyen de séparation électrique prévu pour empêcher l'application de signaux sur au moins une ligne spécifique de données E/S en dehors desdits N lignes de données E/S aux colonnes dans ladite configuration de cellules de mémoire électriquement raccordées à la ligne spécifique de données E/S; et
- un quatrième moyen de connexion électrique pour raccorder lesdites colonnes de remplacement à ladite ligne spécifique de données E/S selon lesdites secondes adresses de colonne.

8. Dispositif de mémoire à semi-conducteur selon la revendication 7, dans lequel ledit moyen de séparation électrique est prévu pour séparer, de façon électrique, ladite au moins une ligne spécifique de données E/S des colonnes électriquement raccordées.

9. Dispositif de mémoire à semi-conducteur selon la revendication 7, dans lequel ledit moyen de séparation électrique et ledit quatrième moyen de connexion électrique comprennent respectivement des liaisons fusibles.

10. Dispositif de mémoire à semi-conducteur selon la revendication 7, dans lequel ledit quatrième moyen de connexion électrique comprend :

- N transistors à grille de transfert pour raccorder lesdites colonnes de remplacement à une ligne arbitraire desdites lignes de données E/S selon lesdites secondes adresses de colonne;
- un moyen pour appliquer une certaine tension aux électrodes de grille desdits transistors à grille de transfert; et
- N liaisons fusibles montées entre lesdites électrodes de grille desdits transistors à grille de transfert et un point de potentiel de référence.

11. Dispositif de mémoire à semi-conducteur selon la revendication 7, dans lequel ledit quatrième moyen de connexion électrique comprend :

- N transistors à grille de transfert pour la connexion desdites colonnes de remplacement à une ligne arbitraire desdites N lignes de données E/S selon lesdites secondes adresses de colonne;
- un moyen pour appliquer une certaine tension aux électrodes de grille desdits transistors à grille de transfert via des inverseurs;
- N liaisons fusibles montées entre l'extrémité d'entrée de chacun desdits inverseurs et le point de potentiel d'alimentation; et
- N éléments de grande résistance montés entre ladite extrémité d'entrée de chacun desdits inverseurs et le point de potentiel de référence.

12. Dispositif de mémoire à semi-conducteur selon la revendication 7, dans lequel le moyen de séparation électrique comprend :

- des liaisons fusibles ayant au moins une liaison correspondant à chacune des lignes de données E/S; et
- un moyen pour fixer la ligne de signal de sélection de colonne par rapport à une ligne spécifique de données E/S dans un état inactif indépendamment desdites adresses de colonne en coupant ladite liaison fusible concernant la ligne spécifique de données E/S.

EP 0 378 332 B1

FIG. 1

12

FIG. 2

# FIG. 3

FIG. 4

FIG. 5

## FIG.6